Europäisches Patentamt

European Patent Office

Office européen des brevets

(11) Publication number: **0 364 038**
**A1**

## (12) EUROPEAN PATENT APPLICATION

(21) Application number: 89202531.3

(22) Date of filing: 09.10.89

(51) Int. Cl.5: **H04N 3/15 , G11C 27/04 , H04N 5/335**

The title of the invention has been amended (Guidelines for Examination in the EPO, A-III, 7.3).

(30) Priority: **13.10.88 NL 8802515**

(43) Date of publication of application:
**18.04.90 Bulletin 90/16**

(84) Designated Contracting States:
**DE FR GB IT NL**

(71) Applicant: **N.V. Philips' Gloeilampenfabrieken**
**Groenewoudseweg 1**
**NL-5621 BA Eindhoven(NL)**

(72) Inventor: **Theuwissen, Albert Joseph Pierre**
**c/o INT. OCTROOIBUREAU B.V. Prof.**
**Holstlaan 6**
**NL-5656 AA Eindhoven(NL)**
Inventor: **O'Dwyer, Brian Christopher John**
**c/o INT. OCTROOIBUREAU B.V. Prof.**
**Holstlaan 6**
**NL-5656 AA Eindhoven(NL)**

(74) Representative: **Kooiman, Josephus Johannes**
**Antonius et al**
**INTERNATIONAAL OCTROOIBUREAU B.V.**
**Prof. Holstlaan 6**
**NL-5656 AA Eindhoven(NL)**

(54) Driving clock waveform for solid-state image sensors.

(57) The sensor (FT) comprises a drive shift register (SR) which ensures that information is shifted in the sensor in accordance with the accordion principle. In the known shift register control performed by means of square-wave clock pulse signals (Q), it appears that horizontal stripes may occur in practice when the generated picture signal is displayed. According to the invention these stripes are eliminated by using a clock pulse with at least three levels, while the clock pulse signals may have a staircase or a sawtooth variation. This prevents faulty charge packet blending (t11p) caused by the square-wave clock pulses and results in an optimum charge transport (t11i).

FIG.2b

FIG.2c

EP 0 364 038 A1

# Camera for television, cinematographic and/or photographic recording, including a solid-state image sensor.

The invention relates to a camera for television, cinematographic and/or photographic recording, including a solid-state image sensor for generating a picture signal, which sensor, controlled by clock pulse signals, operates in accordance with the accordion principle of shifting information in the sensor with an opening, a transporting and a closing phase, the opening phase involving an enlargement of picture information elements and a transport of picture information, the transporting phase involving a transport of picture information and the closing phase involving a transport of picture information and a reduction of picture information elements at the appointed locations, said sensor having a drive shift register which comprises a row of register elements outputs of which are coupled to sensor electrodes, while clock pulse inputs are coupled to the row of register elements which comprise a clock pulse-controlled series switch and a subsequent inverter circuit.

Such a camera comprising a frame transfer sensor is known from an Article "The accordion imager, a new solid-state image sensor" in the Journal "Philips Technical Review", Vol. 43, No. 1/2, December 1986, pp. 1 to 8. The drive shift register for each register element comprises an NMOS transistor as a series switch and an inverter circuit comprising a PMOS and an NMOS transistor between supply terminals, while interconnected drain electrodes of these two transistors constitute the register output and are connected to the input of the subsequent register element. The drive shift register shifts the information in accordance with the accordion principle from an image section of the sensor to a storage section whence the picture information becomes available in a line and field-sequential manner via a parallel-in, serious-out shift register at a sensor output for the supply of the picture signal.

It appears in practice that a problem in the form of stripes may occur when displaying the picture signal. Horizontal stripes then occur in the line scan direction in the displayed picture. It is an object of the invention to realise a camera in which this problem of stripes is eliminated if such a problem occurs when displaying the generated picture signal. To this end a camera according to the invention is characterized in that the clock pulse signals have a variation with at least three levels.

The invention is based on the recognition that the stripe problem is caused by an incorrect transport step when shifting the information in accordance with the accordion principle. This incorrect transport step is related with the structure of the clock pulse signal if it has a known signal variation with two levels. Furthermore, the incorrect transport step is related with the different switching speeds for NMOS and PMOS transistors during inversion from positive to negative (from the logic 1 to 0, which is effected rapidly) and from negative to positive (from the logic 0 to 1, which is effected slowly), respectively. The choice of a clock pulse variation with at least three levels prevents the stripe problem when displaying the picture signal because the transport step is optimized thereby.

The clock pulse variation with at least three levels can be realised with a staircase-shaped variation with three levels or with a sawtooth-shaped variation with a very large number of levels.

It is to be noted that the use of a staircase-shaped or sawtooth-shaped variation for clock pulses to be applied to sensor electrodes of a solid-state image sensor is known from an Article entitled "Influence of clocking waveform on charge transfer in three phase charge-coupled devices" published in "Solid-State Electronics", Vol. 19. No. 4, April 1976, Pergamon Press (GB), pages 279-287. The clock pulses with the indicated variation are active as such with this variation for the information transport in the sensor itself. However, according to the present invention the information transport in the sensor itself is effected under the control of clock pulses with two levels which are, however, obtained from the drive shift register at which the clock pulses with the at least three levels are applied to the series switches of the shift register elements.

The invention will be described in greater detail by way of example with reference to the accompanying drawings in which

Fig. 1a is a diagram of part of an image sensor and Fig. 1b shows an associated charge pattern under sensor electrodes which is obtained in the case of a known two-phase clock pulse control of a drive shift register of the sensor,

Fig. 2a shows a given two-phase clock pulse control according to the invention,

Fig. 2b is a general diagram of register elements of the drive shift register,

Fig. 2c shows the clock pulse control of Fig. 2a and resultant signals,

Fig. 2d shows a resultant charge pattern under the sensor electrodes, and

Figs. 3a, 3b, 3c and 3d are accordingly associated with different choices of the clock pulse variation.

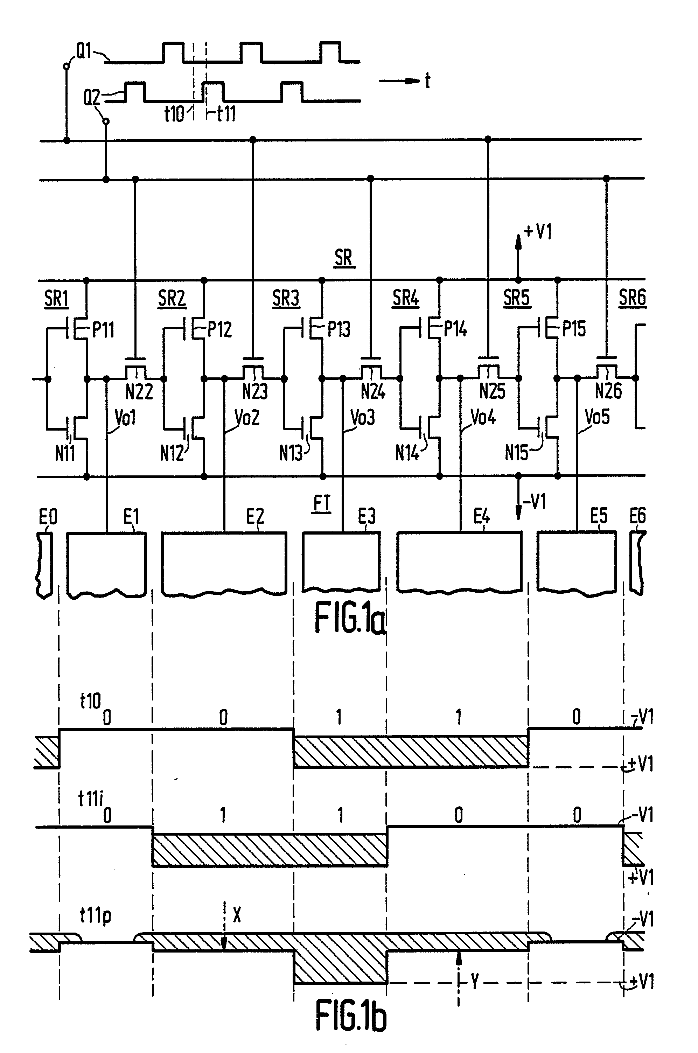

In the diagram of Fig. 1a the reference FT denotes an image sensor whose electrodes E are connected to outputs of a drive shift register SR. The sensor FT is, for example a frame transfer sensor, an interline sensor or a combination thereof. Given electrodes of the sensor electrodes E are denoted by E0, E1, E2 to E6. The electrodes E are shown in part and are assumed to be further extending across or in the sensor FT, insulated from the semiconductor material of the sensor. For a detailed structure of the sensor FT in the form of a frame transfer sensor reference is made to the said Article. The part with the sensor electrodes E shown in Fig. 1a is present, for example in the storage section of the sensor FT. Fig. 1b shows as an example a possible charge pattern which occurs under the electrodes E in the sensor FT, dependent on the voltages which are impressed on the electrodes E. Et is assumed that a positive voltage +V1, which further represents a logic 1, occurs at the electrodes E0, E3 and E4, while a negative voltage -V1, which represents a logic 0, occurs at the electrodes E1, E2, E5 and E6. Fig. 1b shows the associated pattern at an instant t10. Assuming that charge packets of electrons contain picture information, they occur under the positive electrodes E0, E3 and E4, which packets are shaded in the Figure and between which barriers occur. It is assumed that a known pattern 01010101 is associated with the picture recording in the image section (not shown) of the sensor, in which case the known pattern 00110011 is associated with the transporting phase of the information shift in accordance with the accordion principle. After the next transport step a known pattern 01100110 must occur, the left-hand five values of which are shown in Fig. 1b at an instant t11i. The instant t11i is associated with an ideal transport step. Fig. 1a shows the instant t10 and t11 at two clock pulse signals Q1 and Q2 shown as a function of time t. The signals Q1 and Q2 shown occur in the case of a known two-phase clock pulse control of the drive shift register SR. However, in accordance with an aspect of the invention it is not the charge pattern shown at the instant t11i but the pattern shown at an instant t11p which occurs under the control of the clock pulses Q1 and Q2 which are shown in Fig. 1a and vary in a square-wave manner, said instant being associated with the transport step effected in practice. Fig. 1b shows a charge pattern at the instant t11p, which pattern is produced because the barrier at the location X is not yet eliminated, whereas the greater part of the barrier at the location Y is already formed. The shaded charge packet spreads out, as it were, and blends with the adjacent packets. This unwanted blending leads to the stripes occurring in the line scan direction, the horizontal direction when the ultimately obtained picture signal is displayed. The stripe problem is caused by the combination of the information pit under the electrode E3 through which the charge spreads out, which pit is not wide and not deep enough, and by the difference in duration for the slow barrier elimination (X) and the rapid barrier formation (Y), which difference is caused by the drive shift register SR with the square wave clock pulses Q1 and Q2 shown in Fig. 1a.

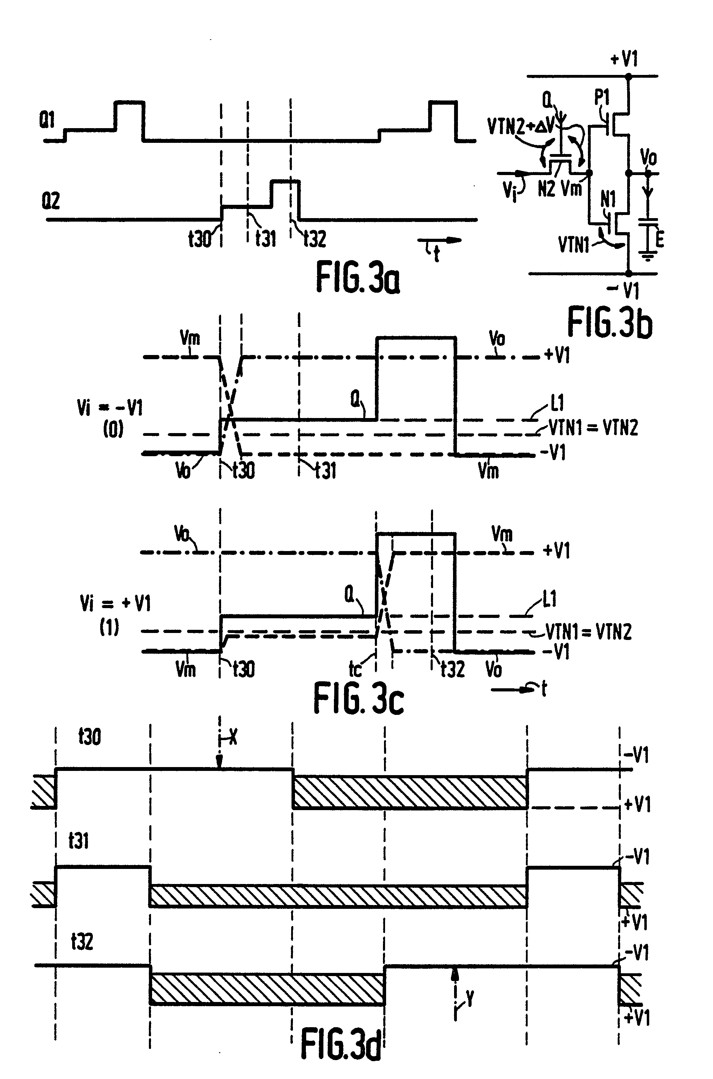

For the sake of completeness and anticipating Figs. 2b and 3b, a brief description will be given of the known drive shift register SR. A row (SR1 ... SR6) of shift register elements SR1 to SR6 of the register SR is shown. Clock pulse-controlled series switches are shown as NMOS transistors N22 to N26. Inverter circuits are formed with PMOS transistors P11 to P15, and NMOS transistors N11 to N15. Drain electrodes of the transistors P11 ... P15, N11 ... N15 constitute the register outputs at which respective output voltages Vo1, Vo2, Vo3, Vo4 and Vo5 occur which are to be supplied to the electrodes E1 ... E5. Source electrodes of the transistors P11 ... P15 and N11 ... N15 are connected to supply terminals conveying voltages +V1 and -V1, respectively. It will be obvious that one of the two supply terminals may be connected to ground. The interconnected gate electrodes of the transistors P11, N11 and so forth to P15, N15 are connected to the drain or source electrode of the preceding series switch transistor, the interconnected gate electrodes of the transistors N23 and N25, and N22, N24 and N26 receiving the clock pulse signals Q1 and Q2, respectively. In the transistors N22 ... N26 the electrode having the highest voltage operates as a drain electrode and the electrode having the lowest voltage operates as a source electrode.

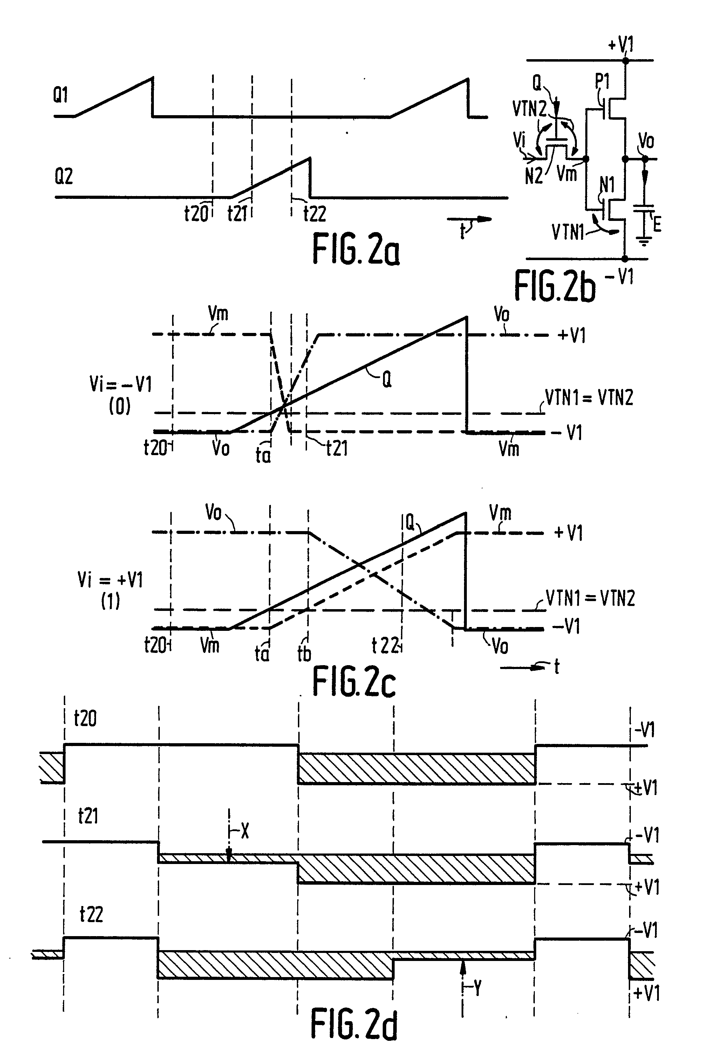

In accordance with a measure of the invention the sawtooth-varying clock pulse signals Q1 and Q2 shown as a function of time t in Fig. 2a are used for controlling the shift register SR of Fig. 1a. The refernces t20, t21 and t22 denote three instants. The instant t20 corresponds to the instant t10 shown in Fig. 1a, which also holds true for the associated voltage patterns of Figs. 1b and 2d. Fig 2b shows a shift register element by means of general indications. The transistors P1, N1 and N2 correspond to the transistors shown in the same configuration in Fig. 1a. The output voltage is denoted Vo and it is applied to the electrode E shown as a capacitance. The input voltage is denoted Vi and is the voltage Vo of the preceding register element. The reference Vm denotes the voltage at the input of the inverter circuit (P2, N2). A clock pulse Q is applied to the gate electrode of the transistor N2. A gate-source threshold voltage of the transistors N1 and N2 is denoted by VTN1 and VTN2, respectively. For Vi is smaller than Vm the electrode conveying the voltage Vi operates as a source electrode and for Vi is larger than Vm the electrode conveying the voltage Vm operates as a source electrode.

Fig. 2c shows as a function of time t the variation of the clock pulse Q (solid lines), the voltage Vm (broken lines) and the output voltage Vo (dot and dash lines) for the case where Vi = -V1 at the instant t20, i.e. the logic 1 is present, or Vi = +V1, i.e. the logic 1 is present. The threshold voltage VTN1 - VTN2 is plotted as a voltage level located between the supply voltages +V1 and -V1.

At Vi = -V1 shown in Fig. 2c it holds for the initial state that Vm = +V1 and Vo = -V1, with the transistor N1 of Fig. 2b being turned on and the transistors P1 and N2 being turned off. At an instant ta the voltage of the clock pulse Q reaches the threshold value VTN2 so that the transistor N2 starts conducting and the voltage Vm decreases. In this case the transistor P1 will be turned on and the transistor N1 will be turned off, whereafter it holds that Vo = +V1 and Vm = -V1 with the fully turned-on transistor P1 and turned-off transistor N1. A charge transport under electrodes E accompanies the transition of the voltage Vo from -V1 to +V1. It is assumed that the pattern shown at Fig. 2d is present at the indicated instant t21. The barrier being eliminated at X is shown with -V1 < Vo < +V1 associated with Vi = -V1 (and Vi = 0).

Vi = +V1 (and Vi = 1) of Fig. 2c is associated with the barrier being formed at Y in accordance with Fig. 2d. For the initial state it holds that Vm = -V1 and Vo = +V1, the transistor P1 of Fig. 2b being turned on and the transistors N1 and N2 being turned off. At the instant ta the voltage of the clock pulse Q reaches the gate-source threshold voltage VTN2, so that the transistor N2 is turned on and the voltage Vm increases with an increase of the clock pulse voltage. At an instant tb the voltage Vm reaches the treshold value VTN1 so that the transistor N1 is turned on while the transistor P1 is turned off. With the subsequently fully turned-on transistor N1 and turned-off transistor P1 it holds that Vo = -V1 and Vm = +V1. A charge transport under electrode E accompanies the transition of the voltage Vo from +V1 to -V1. It is assumed that the pattern shown at Fig. 2d is present at the indicated instant t22 with the barrier being formed at Y.

Figs. 2c and 2d show that the barrier elimination at X is initiated earlier than the barrier formation at Y. With the continuous elimination there is the trailing formation. An optimum transport step is the result, as it shown by means of a comparison of the pattern at the instant t11p of Fig. 1b with the pattern at the instant t22 of Fig. 2d.

In accordance with another measure of the invention the staircase-varying clock pulse signals Q1 and Q2 shown as a function of time t in Fig. 3a are used. The references t31 and t32 denote instants which are comparable with the instants t21 and t22 of Fig. 2a, while the instant t30 is shown at a later point of time than the instant t20. Fig. 3a shows the clock pulse signals having a staircase variation with three levels. What is common with the sawtooth variation shown in Fig. 2a is that the two signal variations have at least three levels. The sawtooth variation may be formed with a staircase variation having a large number of levels. Instead of the clock pulse variation, shown in Fig. 3a, with a succession of the lowest, the central, the highest and the lowest level, a variation with the sequence of the lowest, the central, the lowest, the highest and the lowest level may be present. Then there is a staircase-shaped variation with non-contiguous steps.

Fig. 3b shows a gate-source threshold voltage indicated by VTN2 + ΔV which is changed with respect to that in Fig. 2b. This change will be referred to when describing a voltage level L1 in Fig. 3c.

Similarly as described with reference to Fig. 2c, Fig. 3c shows the clock pulses Q and the voltage variations Vm and Vo.

At Vi = -V1 there is the initial state with Vm = +V1 and Vo = -V1 and the transistor N1 is turned on, while the transistors P1 and N2 are turned off. At the instant t30 the clock pulse Q has a voltage step up to the level L1 which is larger than the gate-threshold voltage VTN2, so that the transistors N2 and P1 are turned on and the transistor N1 is turned off. The transition of the voltage Vo from -V1 to +V1 causes a charge transport under the electrodes E. It is assumed that the charge transport has been completely realised at the instant t31 so that the pattern shown in Fig. 3d is associated therewith. The reference X in Fig. 3d at the pattern at the instant t30 shows that the barrier elimination is initiated at this instant.

At Vi = +V1 there is the initial state with Vm = -V1 and Vo = +V1 and the transistor P1 is turned on, while the transistors N1 and N2 are turned off. At the instant t30 the clock pulse Q has the voltage step up to the level L1. The transistor N2 then has the voltage Vi = +V1 at the drain electrode, the clock pulse voltage Q = L1 at the gate electrode and the voltage Vm = -V1 at the source electrode. Since the voltage level L1 is larger than the gate-source threshold voltage VTN2, the transistor N2 is biased for turning on and the voltage Vm acquires the variation shown, while the transistor N1 remains turned off and the transistor P1 remains turned on due to a given choice of the voltage level L1. This state continues until the next voltage step up to the higher level occurs in the clock pulse Q at an instant tc. The transistors N2 and N1 are then turned on, while the transistor P1 is turned off. The transition of the voltage Vo from +V1 to -V1 causes a charge transport under electrodes E. It is assumed that the charge transport is completely realised at the instant t32 so that the pattern shown in Fig. 3d is associated therewith. In Fig. 3d the reference Y at the pattern at the instant t32 shows that the barrier formation is finished at this instant.

For the given voltage level L1 it holds that it should be larger than the gate-source threshold voltage of the transistor N2, but smaller than the sum of the threshold voltages of the two transistors N1 and N2. The high voltage Vi - Vm with a slightly smaller value than 2V1 occurs between source and drain electrode of the transistor N2, which involves an increase of the threshold voltage by a value· of ΔV. In this case it is assumed that the voltage -V1 is impressed on the substrate of the transistor .N2. Based on the foregoing, the following relation must be satisfied:

VTN2 < L1 < (VTN1 + VTN2 + ΔV).

The use of the clock pulses Q of Figs. 2a and 3a with at least three levels, optimising the charge transport under the electrodes E of Fig. 1a, introduces an intermediate stop at the charge transport. Starting from a logic pattern 00110011 at the electrodes E, an intermediate pattern 01110111 is firstly formed, which is followed by the final pattern 001100110. In the case where the known square-wave clock pulses Q of Fig. 1a are used, a non-optimum transition pattern 00100010 automatically occurs, resulting, as described, in the charge packets blending with one another and in the horizontal stripes in the displayed picture.

The transporting phase at the information shift in accordance with the accordion principle has been described hereinbefore by way of example. The clock pulses Q with at least the three levels may be operative without any further problems and with the same advantages in the opening and closing phases in accordance with the accordion principle. Furthermore, a three-phase, four-phase or multi-phase control may be used.

## Claims

1. A camera for television, cinematographic and/or photographic recording, including a solid-state image sensor for generating a picture signal, which sensor, controlled by clock pulse signals, operates in accordance with the accordion principle of shifting information in the sensor with an opening, a transporting and the closing phase, the opening phase involving an enlargement of picture information element and a transport of picture information, the transporting phase involving a transport of picture information and the closing phase involving a transport of picture information and a reduction of picture information elements at the appointed locations, said sensor having a drive shift register which comprises a row of register elements outputs of which are coupled to sensor electrodes, while clock pulse inputs are coupled to the row of register elements which comprise a clock pulse-controlled series switch and a subsequent inverter circuit, characterized in that the clock pulse signals have a variation with at least three levels.

2. A camera as claimed in Claim 1, characterized in that the clock pulse signals have a staircase variation.

3. A camera as claimed in Claim 1, characterized in that the clock pulse signals have a sawtooth variation.

EP 0 364 038 A1

FIG.1a

FIG.1b

1-III-PHN 12705

FIG.2a

FIG.2b

FIG.2c

FIG.2d

FIG.3a

FIG.3b

FIG.3c

FIG.3d

3-Ⅲ-PHN 12705

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 161 023 (N.V. PHILIPS' GLOEILAMPENFABRIEKEN) <br> * Page 12, line 33 - page 21, line 4; figure 5 * <br> --- | 1 | H 04 N 3/15 <br> G 11 C 27/04 <br> H 04 N 5/335 |
| A,D | SOLID-STATE ELECTRONICS, vol. 19, no. 4, April 1976, pages 279-287, Pergamon Press, GB; M.P. SINGH et al.: "Influence of clocking waveform on charge transfer in three phase charge coupled devices" <br> * Page 279, paragraph: "Introduction"; page 286, paragraph: "Conclusion"; figure 1 * <br> ----- | 1,2,3 | |

TECHNICAL FIELDS
SEARCHED (Int. Cl.5)

H 04 N 3
H 04 N 5
H 01 L 27
H 03 J 17
H 03 J 19
G 11 C 27

The present search report has been drawn up for all claims

| Place of search | Date of completion of the search | Examiner |
|---|---|---|
| THE HAGUE | 03-01-1990 | DUHR R.H.J.E. |